# EUROPÄISCHE PATENTSCHRIFT

(11) **EP 1 981 137 B1**
(45) Veröffentlichungstag und Bekanntmachung des Hinweises auf die Patenterteilung: **01.07.2020**
(21) Anmeldenummer: 08001541.5
(22) Anmeldetag: 28.01.2008
(51) Int. Cl.: B82Y 20/00, H01S 5/16, H01S 5/343, H01S 5/10, H01S 5/20, H01S 5/34

(54) **Integrierte Trapezlaseranordnung und Verfahren zu deren Herstellung**
Integrated trapeze laser device and method for its production
Système de laser trapézoïdal intégré et procédé destiné à sa fabrication

(30) Priorität: 28.02.2007 DE 102007009837; 12.06.2007 DE 102007026925
(43) Veröffentlichungstag der Anmeldung: 15.10.2008
(73) Patentinhaber: OSRAM Opto Semiconductors GmbH, 93055 Regensburg (DE)
(72) Erfinder: Eberhard, Franz, Dr., 93059 Regensburg (DE); Schmid, Wolfgang, Dr., 93180 Deuerling / Hillohe (DE); Schlereth, Thomas, 97072 Würzburg (DE)
(74) Vertreter: Epping - Hermann - Fischer

(56) Entgegenhaltungen:
- EP-A1- 0 529 817
- EP-A2- 0 696 747
- US-A- 4 802 182

## Beschreibung

Die vorliegende Erfindung betrifft eine integrierte Halbleiterlaservorrichtung sowie ein Verfahren zu deren Herstellung.

Besonders hohe Ausgangsleistungen bei zugleich guter Strahlqualität sind mit sogenannten Trapezlasern (Tapered Diode Laser) erreichbar. Diese Halbleiterlaser weisen einen sich in Abstrahlungsrichtung lateral verbreiternden Verstärkungsbereich auf und können beispielsweise infrarote Laserstrahlung mit einer Strahlungsleistung im Watt-Bereich erzeugen. Ein derartiger Laser ist beispielsweise in Sumpf el al., Electron. Lett. 38, 2002, pp. 183-184 oder in der Druckschrift EP 0 529 817 A1 beschrieben. Die letztgenannte Druckschrift verweist bezüglich der Ausbildung des Wellenleiters auf das in der Druckschrift US 4,870,652 beschriebene sogenannte "impurity induced disordering"-Verfahren. In der Druckschrift EP 0 696 747 A2 ist ein integriertes Wellenleiterhalbleiterbauelement angegeben.

Trapezlaser umfassen normalerweise einen Injektorbereich und einen sich daran anschließenden trapezförmigen Bereich. Der trapezförmige Bereich hat einen sich trapezförmig aufweitenden Querschnitt ausgehend von dem Injektorbereich. Breitet sich eine Lichtwelle ausgehend vom Injektorbereich in Richtung des trapezförmigen Bereichs aus, so kommt es am Übergang zwischen diesen beiden Bereichen zu einer Aufbeugung der Wellenfront. In dem trapezförmigen Bereich erfolgt eine Verstärkung der Welle. Reflektierende Begrenzungsflächen der Trapezlaseranordnung können so beschichtet sein, dass die entstehende Rückkopplung ausreicht, um die Selbstoszillation in Gang zu setzen.

Eine am Injektorbereich vorgesehene Facette kann eine höher reflektierende Beschichtung haben, während eine Austrittsfacette an einem dem Injektorbereich abgewandten Ende des sich aufweitenden Bereichs eine niedrigere Reflektivität aufweist.

Trapezlaser zeichnen sich insbesondere durch die verhältnismäßig hohe optische Ausgangsleistung bei gleichzeitig guter Strahlqualität aus.

Aufgabe der vorliegenden Erfindung ist es, eine integrierte Trapezlaseranordnung und ein Verfahren zu deren Herstellung anzugeben, die eine größere Flexibilität bei der Einstellung der optischen Eigenschaften des Trapezlasers erlauben.

Erfindungsgemäß wird die Aufgabe durch eine integrierte Trapezlaseranordnung gemäß Patentanspruch 1 sowie ein Verfahren zur Herstellung einer integrierten Trapezlaseranordnung nach Patentanspruch 7 gelöst. Vorteilhafte Ausgestaltungen des vorgeschlagenen Prinzips sind jeweils Gegenstand der abhängigen Patentansprüche.

Die integrierte Trapezlaseranordnung umfasst einen Injektorbereich und einen optisch an den Injektorbereich gekoppelten, verstärkenden und sich in einem Querschnitt aufweitenden Bereich. Zumindest einer dieser Bereiche umfasst zumindest teilweise eine aktive Zone mit einer Mehrzahl von Halbleitermaterialien, wobei die Halbleitermaterialien zumindest in einem Gebiet durchmischt sind. In dem zumindest einen durchmischten Gebiet ist der elektronische Bandabstand vergrößert.

Die aktive Zone beziehungsweise aktive Struktur mit einer Mehrzahl von Halbleitermaterialien kann eine Quantentrogstruktur mit einer Mehrzahl von Halbleitermaterialien umfassen. Das vorliegende Prinzip ist jedoch nicht auf eine Quantentrogstruktur begrenzt, sondern auch bei anderen Strukturen, beispielsweise Doppelheterostrukturen, anwendbar.

Ein Halbleiterlaser mit einem Verstärkungsbereich, dessen Breite in einer Hauptabstrahlungsrichtung zunimmt, wird im Folgenden kurz als Trapezlaser bezeichnet. Derartige Laser können kostengünstig mit Standardherstellungsverfahren der Halbleitertechnologie gefertigt werden und weisen zudem eine vorteilhaft hohe Ausgangsleistung sowie eine hohe Strahlqualität auf.

Die Bezeichnung Quantentrogstruktur umfasst im Rahmen der Anmeldung insbesondere jegliche Struktur, bei der Ladungsträger durch Einschluss ("confinement") eine Quantisierung ihrer Energiezustände erfahren können. Insbesondere beinhaltet die Bezeichnung Quantentrogstruktur keine Angabe über die Dimensionalität der Quantisierung. Sie umfasst somit u.a. Quantentröge, Quantentöpfe, Quantendrähte, Quantenfilme und Quantenpunkte und jede Kombination dieser Strukturen. Auch sogenannte Quantum Dashes, in eine Vorzugsrichtung verlängerte Quantenpunkte, sind vorliegend umfasst.

Das Durchmischen ermöglicht insgesamt eine lokale Änderung der Bandlücke, wodurch in exakter und zugleich einfacher Weise Bereiche definiert werden können, in denen die Bandlücke höher ist als im umgebenden Material. Dies kann zur flexiblen gleichzeitigen Herstellung unterschiedlicher optisch aktiver und passiver Bereiche genutzt werden.

Der im Vergleich zu nicht durchmischten Bereichen erhöhte elektronische Bandabstand der durchmischten Bereiche der Quantentrogstruktur kann sich in mehrfacher Hinsicht positiv auf die Brillanz, beispielsweise Strahlqualität und maximale Ausgangsleistung, des Lasers auswirken. Einerseits wird die Reabsorption von Strahlung, die in der Quantentrogstruktur emittiert wird und auf dem Weg bis zur Auskopplung die durchmischten Bereiche der Quantentrogstruktur durchquert, vermindert, da die Energie dieser Strahlung geringer ist als der elektronische Bandabstand der durchmischten Bereiche. Weiterhin kann die Effizienz des Lasers dadurch erhöht werden, dass sich elektronische Ladungsträger bevorzugt in Bereiche mit geringerem Bandabstand bewegen, wodurch die Anzahl der Ladungsträger in den zur Strahlungserzeugung vorgesehenen Bereichen der Quantentrogstruktur und damit auch die Anzahl der strahlenden Rekombinationen erhöht wird.

Der Injektorbereich umfasst bevorzugt einen einmodigen Wellenleiterbereich.

Der sich aufweitende Bereich ist bevorzugt trapezförmig ausgebildet. Dabei kann die schmalere der beiden parallelen Seiten des Trapezes in einer optischen Kopplung mit dem Injektorbereich verbunden sein. Die längere der beiden parallelen Seiten des Trapezes ist bevorzugt als Austrittsfläche ausgebildet. In einer Ausführungsform ergibt sich die Trapezform bei einer Draufsicht auf die integrierte Trapezlaseranordnung.

In einer Ausführungsform grenzt der sich aufweitende Bereich unmittelbar an den Injektorbereich an. Dabei kann der sich aufweitende Bereich einen Querschnitt haben, der sich ausgehend von dem Querschnitt des Injektorbereichs in einer Hauptstrahlrichtung vergrößert.

An einem dem Injektorbereich abgewandten Ende des sich aufweitenden Bereichs kann eine Austrittsfacette vorgesehen sein.

An einem dem sich aufweitenden Bereich abgewandten Ende des Injektorbereichs kann eine hochreflektive Facette vorgesehen sein.

Die Reflektivität der Austrittsfacette ist bevorzugt geringer als die der hochreflektiven Facette.

Die hochreflektive Facette und/oder die Austrittsfacette können einen nichtabsorbierenden Spiegelbereich umfassen, der als durchmischtes Gebiet ausgebildet ist. Nichtabsorbierende Spiegelbereiche werden auch als NAM, non-absorbing mirrors bezeichnet.

Das gezielte Durchmischen von Facettenbereichen führt zu einer Erhöhung der Bandlücke und damit zu einer Verringerung der Absorption in diesen Bereichen. Darüber hinaus tragen die durchmischten Bereiche nicht mehr zur Laseraktivität bei. Deshalb verringert sich die Temperaturbelastung der Facetten, was wiederum höhere Ausgangsleistungen des Lasers ermöglicht.

Zwischen dem sich aufweitenden Bereich und dem Injektorbereich ist ein Freilaufbereich vorgesehen. Der Freilaufbereich hat eine gegenüber dem sich aufweitenden Bereich reduzierte Verstärkung und ist als durchmischtes Gebiet ausgebildet. Bevorzugt ist der Freilaufbereich als nichtabsorbierender Bereich ausgebildet.

Ein durchmischter Freilaufbereich mit erhöhter Bandlücke repräsentiert ein optisch passives Gebiet. Dies gilt auch dann, wenn eine Metallisierung durchgängig angeschlossen ist. Absorption und Verstärkung werden im Freilaufbereich somit stark unterdrückt, wodurch die Modenstruktur einer aus dem Injektorbereich in den verstärkenden, sich aufweitenden Bereich injizierten Strahlung nicht gestört wird. Somit ergibt sich durch den Freilaufbereich eine verbesserte Strahlqualität.

Der sich aufweitende Bereich kann zumindest einen Randbereich umfassen, der sich in einer Richtung vom Injektorbereich zu einem Ende des sich aufweitenden Bereichs erstreckt, wobei der zumindest eine Randbereich als durchmischtes Gebiet ausgebildet ist.

Durch gezielte Beeinflussung der Bandlücke im sich aufweitenden Bereich kann der lokale Gewinn an das Modenprofil in diesem Bereich angepasst werden. Dadurch wird insgesamt die Strahlqualität erhöht. Dabei kann erreicht werden, dass ein Maximum eines spektralen Gewinns zu kürzeren Wellenlängen hin verschoben wird. Strahlung aus dem Injektorbereich wird in diesen durchmischten Bereichen weniger verstärkt. Zum anderen kann erreicht werden, dass wegen der höheren Bandlücke die durchmischten Gebiete weniger stark elektrisch gepumpt werden.

Der Injektorbereich umfasst in einer Ausführungsform zumindest ein Injektorrandgebiet, das sich in einer Richtung von dem sich aufweitenden Bereich zu einem Ende des Injektorbereichs erstreckt, wobei das zumindest eine Injektorrandgebiet als durchmischtes Gebiet ausgebildet ist.

Durch die Erzeugung von Bereichen mit erhöhter Bandlücke ist eine besonders feine Definition eines einmodigen Injektors möglich. Gegenüber einem alternativ möglichen Ätzverfahren hat das vorgeschlagene Prinzip den Vorteil, dass die gesamte Struktur planar ist. Eine weitere Prozessierung ist damit deutlich vereinfacht.

In einer alternativen, vorliegend nicht beanspruchten Ausgestaltung sind der gesamte Injektorbereich und der gesamte sich aufweitende Bereich der Trapezlaseranordnung als durchmischtes Gebiet ausgebildet.

Durch das Durchmischen der gesamten Trapezlaserstruktur kann man erreichen, dass das umgebende Material eine niedrigere Bandlücke besitzt als der Laser selbst. Dadurch kann Licht, das den sich aufweitenden Bereich nach einer Rückreflektion an der Austrittsfacette seitlich verlässt, sehr effektiv absorbiert werden und wird nicht in den Injektor zurück reflektiert.

Insgesamt können damit Absorberstrukturen in den Trapezlaser umgebenden Bereichen realisiert werden.

Zusätzlich zu dem Vorteil der größeren Flexibilität bei der Herstellung unterschiedlicher optisch aktiver und passiver Bereiche bietet das vorgeschlagene Prinzip in allen Ausführungsformen den Vorteil, dass viele, aufwändigere Prozessschritte wie zum Beispiel Oxidieren, Ätzen, Strukturieren von Kontakten usw. durch einen technologisch einfacheren Prozessschritt ersetzt werden können.

Auch eine Kombination der vorgeschlagenen Ausführungsformen ist insgesamt mit lediglich einem Prozessschritt realisierbar.

Die Herstellung des oder der durchmischten Bereiche der Quantentrogstruktur erfolgt vorzugsweise durch einen diffusionsinduzierten Durchmischungsprozess (DID).

Ein solches Herstellungsverfahren ist beispielsweise unter der Abkürzung QWI, quantum well intermixing bekannt.

Vorliegend fällt unter einen diffusionsinduzierten Durchmischungsprozess beispielsweise ein Verfahren, bei dem nach der Herstellung einer Quantentrogstruktur auf die zur Durchmischung vorgesehenen Bereiche eine Schicht aufgebracht wird, wobei eine der Komponenten des Halbleitermaterials der Quantentrogstruktur bei einer geeignet hohen Temperatur eine bevorzugte Diffusionsbewegung in Richtung dieser Schicht aufweist. Die aufgebrachte Schicht kann beispielsweise Siliziumnitrid enthalten. Die Diffusionsbewegung wird durch einen Temperschritt bei einer entsprechend hohen Temperatur ausgelöst. Die Diffusionsbewegung erzeugt Leerstellen an der Oberfläche der Quantentrogstruktur. Die so erzeugten Leerstellen diffundieren weiter innerhalb der Quantentrogstruktur, wodurch eine Durchmischung der Quantentrogstruktur bewirkt wird.

Andere Verfahren des diffusionsinduzierten Durchmischens umfassen eine Diffusion von Fremdatomen, die mittels Implantation oder durch Diffusion aus geeigneten Schichten in den Halbleiter gelangen. Derartige Schichten können bereits während der Herstellung eines III-V-Materials eingebracht oder nachträglich aufgebracht werden.

Neben dem oben beschriebenen diffusionsinduzierten Durchmischen durch sogenanntes impurity free vacancy disordering, IFVD, können somit auch andere Verfahren wie beispielsweise impurity induced disordering, laser induced disordering, implantation induced disordering et cetera eingesetzt werden.

Bei den Halbleitermaterialien der Quantentrogstruktur handelt es sich beispielsweise um einen III-V-Halbleiter, insbesondere um einen Gallium umfassenden III-V-Halbleiter.

Die aufgebrachte Schicht kann beispielsweise eine Siliziumnitridschicht sein. Das beschriebene Verfahren hat den Vorteil einer verhältnismäßig einfachen Prozessführung und damit vergleichsweise geringen Kosten.

Insbesondere bei diffusionsinduzierter Durchmischung mittels impurity free vacancy disordering, IFVD kann die aufgebrachte Schicht Siliziumoxid, SiO, enthalten.

Die Erfindung wird nachfolgend anhand von mehreren Beispielen und einem erfindungsgemäßen Ausführungsbeispiel in Zusammenhang mit den Figuren näher erläutert.

Es zeigen:
- Figur 1: einen schematisch dargestellten Schnitt durch ein vorliegend nicht beanspruchtes Beispiel einer Trapezlaseranordnung ,
- Figur 2: einen schematisch dargestellten Schnitt durch ein erfindungsgemäßes Ausführungsbeispiel einer Trapezlaseranordnung,
- Figur 3: einen schematisch dargestellten Schnitt durch ein vorliegend nicht beanspruchtes Beispiel einer Trapezlaseranordnung,
- Figur 4: einen schematisch dargestellten Schnitt durch ein vorliegend nicht beanspruchtes Beispiel einer Trapezlaseranordnung,
- Figur 5: einen schematisch dargestellten Schnitt durch ein vorliegend nicht beanspruchtes Beispiel einer Trapezlaseranordnung,
- Figur 6: eine Galliumarsenid/Aluminiumarsenid Quantentrogstruktur vor und nach einer diffusionsinduzierten Durchmischung und
- Figur 7: das Leitungs- und Valenzband vor und nach der diffusionsinduzierten Durchmischung.

Bei der Beschreibung der Ausführungsbeispiele und Beispiele sind gleiche oder gleich wirkende Elemente in den Figuren mit gleichen Bezugszeichen versehen.

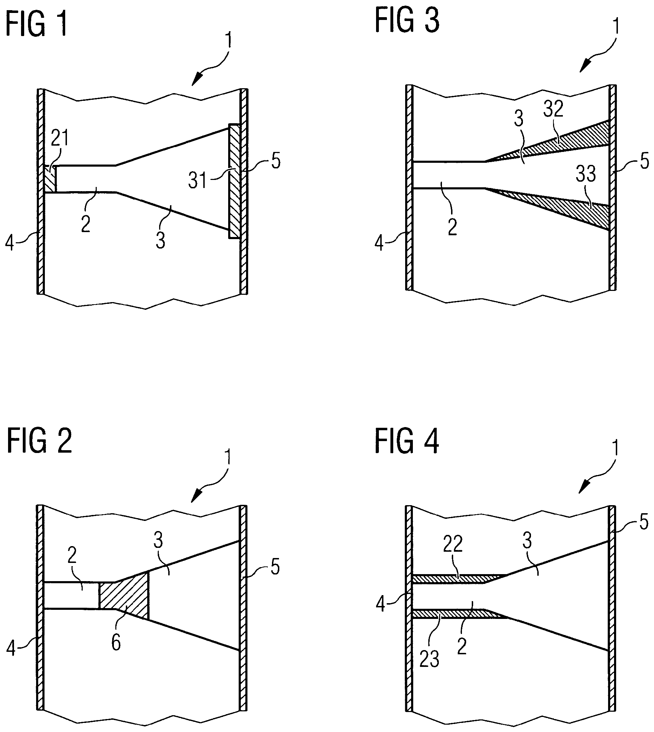

Bei dem in Figur 1 gezeigten Beispiel einer Trapezlaseranordnung schließt sich an einen Injektorbereich 2 unmittelbar ein sich trapezförmig im Querschnitt aufweitender Bereich 3 an. Der Injektorbereich 2 ist an einem von dem sich aufweitenden Bereich 3 abgewandten Ende durch eine hochreflektive Facette 4 abgeschlossen. Der sich aufweitende Bereich 3 hingegen ist an dem vom Injektorbereich 2 abgewandten Ende durch eine Austrittsfacette 5 abgeschlossen. Die hochreflektive Facette 4 umfasst ebenso wie die Austrittsfacette 5 je einen nichtabsorbierenden Spiegelbereich 21, 31, welche als diffusionsinduziertes Durchmischungsgebiet realisiert sind. Demnach ist in den nichtabsorbierenden Spiegelbereichen 21, 31 die elektronische Bandlücke gegenüber dem Injektorbereich 2 und dem sich aufweitenden Bereich 3 erhöht.

Dieses gezielte Durchmischen in den Facettenbereichen führt in diesen Bereichen zu einer Verringerung der Absorption. Darüber hinaus tragen diese Bereiche 21, 31 nicht mehr zur Laseraktivität bei. Dies wiederum führt zu einer verringerten Temperaturbelastung an den Facetten 4, 5, was insgesamt eine höhere maximale Ausgangsleistung des Lasers 1 von Figur 1 ermöglicht.

Bei der erfindungsgemäßen Ausführung gemäß Figur 2 ist zwischen dem Injektorbereich 2 und dem sich aufweitenden Bereich 3 ein zusätzlicher Freilaufbereich vorgesehen. Der Freilaufbereich 6 ist als diffusionsinduziertes Durchmischungsgebiet ausgebildet und somit mit gegenüber den Injektor- und sich aufweitenden Bereichen 2, 3 mit erhöhter Bandlücke versehen. Der durchmischte Freilaufbereich 6 stellt somit ein optisch passives Gebiet dar. Absorption und Verstärkung werden in diesem Gebiet stark unterdrückt. Dadurch wird die Modenstruktur, die die in den trapezförmigen Bereich injizierte Strahlung aufweist, nicht unerwünscht gestört.

Figur 3 zeigt ein Beispiel, bei dem durchmischte Gebiete entlang derjenigen Seiten der Trapezlaseranordnung vorgesehen sind, die sich von dem Injektorbereich 2 bis zu einem dem Injektorbereich 2 abgewandten Ende des sich aufweitenden Bereichs 3, vorliegend bis zur Austrittsfacette 5 erstrecken. Die durchmischten Gebiete 32, 33 weisen dabei selbst ausgehend vom Injektorbereich 2 einen zunehmenden Querschnitt auf in Richtung zur Austrittsfacette 5.

Durch das Durchmischen bestimmter Bereiche im sich aufweitenden Bereich kann die Verstärkung dem Profil der gewünschten Mode der Strahlung angepasst werden. Das Maximum des spektralen Gewinns wird dabei zu kürzeren Wellenlängen hin verschoben. Die Strahlung wird somit in den durchmischten Bereichen 32, 33 weniger verstärkt als im verbleibenden sich aufweitenden Bereich 3. Aufgrund ihrer höheren Bandlücke werden die Randbereiche 32, 33 weniger stark elektrisch gepumpt.

In den Randbereichen 32, 33 wird der Quantenfilm nicht aufgelöst, aber verändert, sodass sich ein verändertes Gewinnspektrum ergibt.
In alternativen Ausführungen können sich die Randbereiche 32, 33 über signifikant größere Bereiche erstrecken. Beispielsweise könnte der gesamte Chip mit Ausnahme eines verbleibenden Injektorbereichs 2 und eines verbleibenden sich aufweitenden Bereichs 3 durchmischt sein.

Figur 4 zeigt eine Trapezlaseranordnung, bei der im Injektorbereich 2 Randgebiete 22, 23 des Wellenleiters als durchmischte Gebiete ausgebildet sind. Diese Injektorrandgebiete 22, 23 erstrecken sich im gezeigten Beispiel im Wesentlichen parallel zueinander und von der hochreflektiven Facette 4 bis zum Übergang des Injektorbereichs 2 in den sich aufweitenden Bereich 3.

Durch Auflösen des Quantenfilms in den Injektorrandgebieten 22, 23 ergibt sich ein verringerter Brechungsindex und damit eine Wellenleiterstruktur. Die geeignete Anordnung durchmischter und nicht durchmischter Gebiete ermöglicht somit in einfacher Weise die Herstellung lateraler einmodiger Wellenleiterstrukturen. Durch die Erzeugung von Bereichen mit erhöhter Bandlücke 22, 23 lässt sich somit in einfacher Weise ein einmodiger Injektor mittels diffusionsinduziertem Durchmischen definieren. Gegenüber anderen Herstellungsverfahren wie Oxidation oder Trockenätzen hat das vorgeschlagene Prinzip den Vorteil, dass sich insgesamt eine ebene Struktur ergibt, was eine einfachere Weiterverarbeitung erlaubt.

In alternativen Ausführungen können sich die Randgebiete 22, 23 über signifikant größere Bereiche erstrecken. Beispielsweise könnte der gesamte Chip mit Ausnahme eines verbleibenden Injektorbereichs 2 und eines verbleibenden sich aufweitenden Bereichs 3 durchmischt sein.

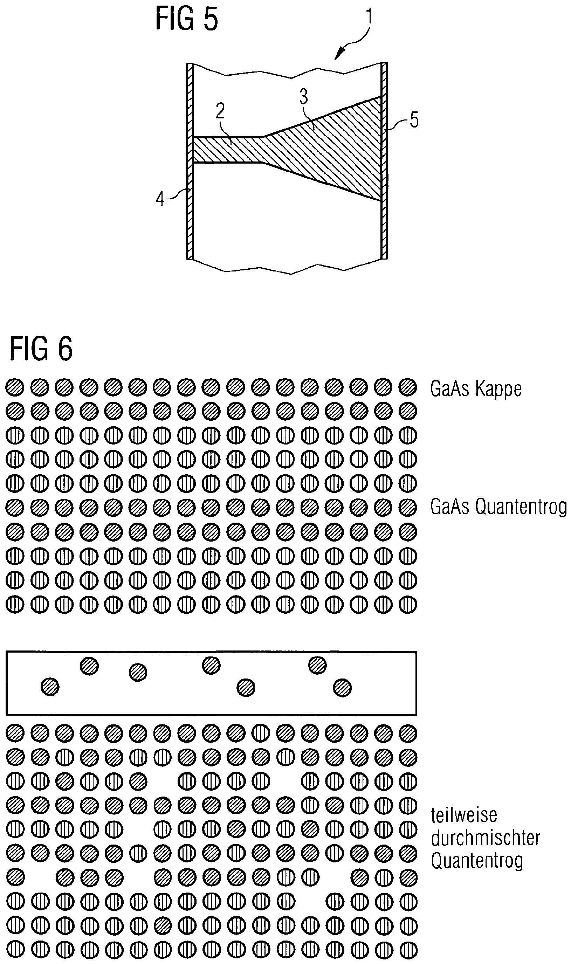

Figur 5 zeigt ein Beispiel, bei dem nicht nur wie in den Figuren 1 bis 4 Teilgebiete des Trapezlasers als durchmischte Gebiete ausgebildet sind, sondern der gesamte Trapezlaser umfassend den gesamten Injektorbereich und der gesamte sich aufweitende Bereich als durchmischte Gebiete ausgeführt sind. Der gesamte Trapezlaser 2, 3 umfassend den Injektorbereich 2 und den sich daran anschließenden aufweitenden Bereich 3 ist als Quantentrogstruktur mit einer Mehrzahl von Halbleitermaterialien ausgebildet, wobei die Halbleitermaterialien in dem gesamten Gebiet 2, 3 durchmischt sind und wobei dieses durchmischte Gebiet einen erhöhten elektronischen Bandabstand aufweist.

Das die Trapezlaserstruktur umgebende Material besitzt somit eine niedrigere Bandlücke als der Laser umfassend den Injektorbereich 2 und den sich aufweitenden Bereich 3 selbst. Licht, welches den sich aufweitenden Bereich nach einer Rückreflektion an der als Auskoppelspiegel ausgebildeten Austrittsfacette 5 seitlich verlässt, kann somit sehr effektiv absorbiert werden und wird nicht in den Injektorbereich 2 zurück reflektiert.

Das vorgeschlagene Prinzip erübrigt ein Bereitstellen von Deflektor-Gräben (Spoilern) oder mit Germanium beschichteten Ätzgräben.

Allen gezeigten Ausführungsformen und Beispielen ist gemeinsam, dass aus Gründen der besseren Übersichtlichkeit elektrische Kontakte bzw. Metallisierungsebenen, welche für das Anregen des Lasers erforderlich sein können, nicht eingezeichnet sind.

Figur 6 zeigt an einem Beispiel die Herstellung eines Gebiets mit diffusionsinduzierter Durchmischung, die auch als QWI, quantum well intermixing bezeichnet wird. Der in dieser Figur gezeigte Prozess wird auch als impurity free vacancy disordering, IFVD bezeichnet. Dabei wird ein III-V-Halbleiter, vorliegend eine Galliumarsenid/Aluminiumarsenid-Struktur mit einer Galliumarsenidkappe und einem Galliumarsenidquantentrog mit einer Siliziumdioxid, SiO2-Schicht versehen. Es erfolgt ein Temperschritt. Bei erhöhten Temperaturen ist das Gallium löslich und hat einen hohen Diffusionskoeffizienten im SiO2. Daher diffundieren während der Temperung einige Galliumatome in die Si02-Kappe. Leerstellen werden erzeugt als Ergebnis davon, dass die Galliumatome den Halbleiter verlassen. Diese Leerstellen selbst haben einen hohen Diffusionskoeffizienten im Halbleiter. Die Leerstellen diffundieren von einer Region mit hoher Konzentration an der Oberfläche zu Gebieten niedrigerer Konzentration, nämlich im restlichen Halbleitergebiet. Dabei folgen einzelne Leerstellen einem zufälligen Bewegungsmuster. Der Effekt dieser zufälligen Bewegungsmuster einer Vielzahl von Leerstellen ist, dass sich eine Durchmischung ergibt. Aluminium- und Galliumatome sind dabei Figur 6 unterschiedlich schraffiert dargestellt.

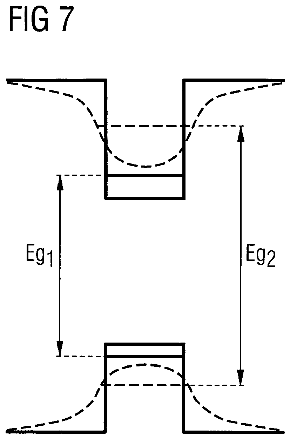

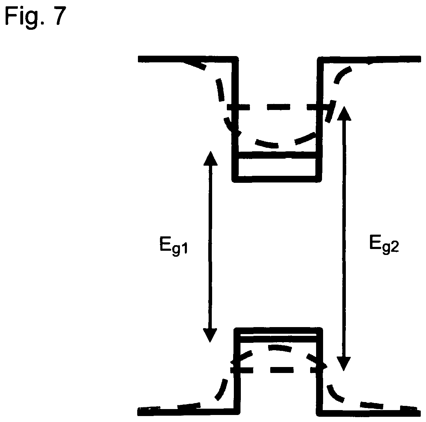

Die Auswirkungen der diffusionsinduzierten Durchmischung sind in der nachfolgenden Figur 7 anhand der Darstellung von Leitungs- und Valenzband dargestellt. Die Verhältnisse nach erfolgter Durchmischung sind gestrichelt eingezeichnet. Die Galliumarsenidschicht realisiert einen Quantentrog. Daher sind die Niveaus von Elektronen und Löchern quantisiert. Die entstehende, effektive Bandlücke E_{g2} ist größer als die Bandlücke E_{g1} bei herkömmlichem, nicht in einem Quantentrog realisiertem Galliumarsenid. Das diffusionsinduzierte Durchmischen führt dazu, dass Aluminium hinein in den Trog und Gallium aus dem Trog heraus diffundiert und dadurch den Trog erweitert sowie seine durchschnittliche Bandlücke erhöht.

Die Erfindung ist nicht durch die Beschreibung anhand der Ausführungsbeispiele beschränkt.

## Patentansprüche

1. Integrierte Trapezlaseranordnung, umfassend
- einen Injektorbereich (2) und
- einen optisch an den Injektorbereich gekoppelten, verstärkenden und sich in einem Querschnitt aufweitenden Bereich (3),
- bei der zumindest einer der Bereiche, umfassend den Injektorbereich (2) und den sich aufweitenden Bereich (3), eine aktive Zone mit einer Mehrzahl von Halbleitermaterialien umfasst, wobei die Halbleitermaterialien zumindest in einem Gebiet durchmischt sind, sodass das durchmischte Gebiet einen größeren elektronischen Bandabstand aufweist als ein nicht durchmischtes Gebiet,
**dadurch gekennzeichnet, dass**
- ein Freilaufbereich (6) mit gegenüber dem sich aufweitenden Bereich reduzierter Verstärkung als durchmischtes Gebiet ausgebildet ist, und
- der Freilaufbereich (6) zwischen dem Injektorbereich (2) und dem sich aufweitenden Bereich (3) angeordnet ist.

2. Trapezlaseranordnung nach Anspruch 1,
bei der der Injektorbereich (2) einen einmodigen Wellenleiterbereich umfasst.

3. Trapezlaseranordnung nach Anspruch 1 oder 2,
bei der der sich aufweitende Bereich (3) trapezförmig ausgebildet ist.

4. Trapezlaseranordnung nach einem der Ansprüche 1 bis 3,
die eine Austrittsfacette (5) umfasst, die an einem dem Injektorbereich (2) abgewandten Ende des sich aufweitenden Bereichs (3) angeordnet ist.

5. Trapezlaseranordnung nach einem der Ansprüche 1 bis 4,
die eine hochreflektive Facette (4) umfasst, die an einem dem sich aufweitenden Bereich (3) abgewandten Ende des Injektorbereichs (2) angeordnet ist.

6. Trapezlaseranordnung nach Anspruch 4 und 5,
bei der zumindest eine der Facetten umfassend die hochreflektive Facette (4) und die Austrittsfacette (5) einen nichtabsorbierenden Spiegelbereich (21, 31) umfasst und der nichtabsorbierende Spiegelbereich (21, 31) als durchmischtes Gebiet ausgebildet ist.

7. Verfahren zur Herstellung einer integrierten Trapezlaseranordnung, umfassend einen Injektorbereich (2) und einen optisch an den Injektorbereich gekoppelten, verstärkenden und sich in einem Querschnitt aufweitenden Bereich (3), bei der zumindest einer der Bereiche, umfassend den Injektorbereich (2) und den sich aufweitenden Bereich (3), eine aktive Struktur mit einer Mehrzahl von Halbleitermaterialien umfasst und die Halbleitermaterialien zumindest in einem Gebiet durchmischt werden zur Erhöhung des elektronischen Bandabstands und wobei
- bei der Herstellung eines Freilaufbereichs (6) eine Durchmischung erfolgt mit gegenüber dem sich aufweitenden Bereich reduzierter Verstärkung, und
- der Freilaufbereich (6) zwischen dem Injektorbereich (2) und dem sich aufweitenden Bereich (3) angeordnet ist.

8. Verfahren nach Anspruch 7,
bei dem das zumindest eine durchmischte Gebiet (21, 31) mit einem diffusionsinduzierten Durchmischungsprozess hergestellt wird.

9. Verfahren nach Anspruch 7 oder 8,
bei dem die aktive Struktur eine Quantentrogstruktur umfasst und bei dem Bereiche der Quantentrogstruktur durch das Aufbringen einer Schicht und einen nachfolgenden Temperschritt, dessen Temperatur dazu geeignet ist, die teilweise Diffusion einer Komponente der die Quantentrogstruktur ausbildenden Halbleitermaterialien in die aufgebrachte Schicht zu bewirken, durchmischt werden.

10. Verfahren nach Anspruch 9,
bei dem die aufgebrachte Schicht eine SiN-Schicht ist.

11. Verfahren nach einem der Ansprüche 7 bis 10,
bei dem die Quantentrogstruktur ein III-V-Halbleitermaterial umfasst.

12. Verfahren nach Anspruch 11,
bei dem das III-V-Halbleitermaterial Gallium umfasst.

13. Verfahren nach einem der Ansprüche 7 bis 12,
bei dem eine hochreflektive Facette (4) am Injektorbereich (2) und/oder eine Austrittsfacette (5) an einem dem Injektorbereich (2) abgewandten Ende des sich aufweitenden Bereichs (3) vorgesehen ist, bei deren Herstellung zumindest teilweise eine Durchmischung erfolgt.

## Claims

1. An integrated tapered diode laser arrangement, comprising
- an injector region (2) and
- a region (3) which is optically coupled to the injector region, amplifies and expands in a cross section,
- in which at least one of the regions, comprising the injector region (2) and the expanding region (3), comprises an active region having a plurality of semiconductor materials, wherein the semiconductor materials are intermixed at least in one region, so that the intermixed region has a larger electronic band gap than a non-intermixed region,
**characterized in that**
- a free propagation region (6) with reduced amplification by comparison with the expanding region is formed as intermixed region, and
- the free propagation region (6) is arranged between the injector region (2) and the expanding region (3).

2. The tapered diode laser arrangement as claimed in claim 1,
in which the injector region (2) comprises a monomode waveguide region.

3. The tapered diode laser arrangement as claimed in claim 1 or 2,
in which the expanding region (3) is formed in trapezoidal fashion.

4. The tapered diode laser arrangement as claimed in one of claims 1 to 3,
which comprises an exit facet (5) arranged at an end of the expanding region (3) which is remote from the injector region (2).

5. The tapered diode laser arrangement as claimed in one of claims 1 to 4,
which comprises a highly reflective facet (4) arranged at an end of the injector region (2) which is remote from the expanding region (3).

6. The tapered diode laser arrangement as claimed in claims 4 and 5,
in which at least one of the facets comprising the highly reflective facet (4) and the exit facet (5) comprises a non-absorbing mirror region (21, 31) and the non-absorbing mirror region (21, 31) is formed as intermixed region.

7. A method for producing an integrated tapered diode laser arrangement, comprising an injector region (2) and a region (3) which is optically coupled to the injector region, amplifies and expands in a cross section, in which at least one of the regions, comprising the injector region (2) and the expanding region (3), comprises an active structure with a plurality of semiconductor materials and the semiconductor materials are intermixed at least in one region in order to increase the electronic band gap and wherein
- during the production of a free propagation region (6) an intermixing is effected with reduced amplification by comparison with the expanding region, and
- the free propagation region (6) is arranged between the injector region (2) and the expanding region (3).

8. The method as claimed in claim 7,
in which the at least one intermixed region (21, 31) is produced by means of a diffusion-induced intermixing process.

9. The method as claimed in claim 7 or 8,
in which the active structure comprises a quantum well structure, and in which regions of the quantum well structure are intermixed by applying a layer and by a subsequent heat treatment step, the temperature of which is suitable for bringing about the partial diffusion of a component of the semiconductor materials forming the quantum well structure into the applied layer.

10. The method as claimed in claim 9,
in which the applied layer is an SiN layer.

11. The method as claimed in one of claims 7 to 10,
in which the quantum well structure comprises a III-V semiconductor material.

12. The method as claimed in claim 11,
in which the III-V semiconductor material comprises gallium.

13. The method as claimed in one of claims 7 to 12,
in which a highly reflective facet (4) is provided at the injector region (2) and/or an exit facet (5) is provided at an end of the expanding region (3) which is remote from the injector region (2), an intermixing being effected at least partly during the production of said facet(s).

## Revendications

1. Disposition de laser trapézoïdal comportant
- une zone d'injecteur (2) et
- une zone accouplée optiquement à la zone d'injecteur, amplificatrice et s'élargissant en une coupe transversale (3),
- pour laquelle au moins une des zones comportant la zone d'injecteur (2) et la zone s'élargissant (3), comporte une zone active avec une pluralité de matériaux semiconducteurs, sachant que les matériaux semiconducteurs sont mélangés au moins dans une région, de sorte que la région mélangée présente un écart de bande électronique plus grand qu'une région non mélangée,
**caractérisée en ce que**
- une zone de régime libre (6) est constituée, avec une amplification en tant que région mélangée réduite par rapport à la zone s'élargissant, et
- la zone de régime libre (6) est disposée entre la zone d'injecteur (2) et la zone s'élargissant (3).

2. Disposition de laser trapézoïdal selon la revendication 1, pour laquelle la zone d'injecteur (2) comporte une zone de guide d'ondes monomode.

3. Disposition de laser trapézoïdal selon les revendications 1 ou 2,
pour laquelle la zone s'élargissant (3) est constituée en forme trapézoïdale.

4. Disposition de laser trapézoïdal selon une quelconque des revendications 1 à 3,
qui comporte une facette de sortie (5) qui est disposée sur une extrémité détournée de la zone d'injecteur (2) de la zone s'élargissant (3).

5. Disposition de laser trapézoïdal selon une quelconque des revendications 1 à 4,
qui comporte une facette hautement réfléchissante (4) qui est disposée sur une extrémité détournée de la zone s'élargissant (2) de la zone d'injecteur (3).

6. Disposition de laser trapézoïdal selon les revendications 4 et 5,
pour laquelle au moins une des facettes comportant la facette hautement réfléchissante (4) et la facette de sortie (5) comporte une zone réflectrice non absorbante (21, 31) et la zone réflectrice non absorbante (21, 31) est constituée comme région mélangée.

7. Procédé en vue de la fabrication d'une disposition de laser trapézoïdal intégrée, comportant une zone d'injecteur (2) et une zone accouplée optiquement à la zone d'injecteur, amplificatrice et s'élargissant en une coupe transversale (3), pour laquelle au moins une des zones comportant la zone d'injecteur (2) et la zone s'élargissant (3) comporte une zone active avec une pluralité de matériaux semiconducteurs et les matériaux semiconducteurs sont mélangés au moins dans une région en vue de l'accroissement de l'écart de bande électronique et sachant que
- pour la fabrication d'une zone de régime libre (6), un mélange s'effectue avec une amplification réduite par rapport à la zone s'élargissant, et
- la zone de régime libre (6) est disposée entre la zone d'injecteur (2) et la zone s'élargissant (3).

8. Procédé selon la revendication 7,
pour lequel au moins l'une des régions mélangées (21, 31) est fabriquée avec un processus de mélange induit par diffusion.

9. Procédé selon les revendications 7 ou 8,
pour lequel la structure active comporte une structure de puits quantique et pour lequel des zones de la structure de puits quantique sont mélangées par l'application d'une couche et par une étape de malléabilisation suivante, dont la température convient à susciter la diffusion partielle d'un composant des matériaux semiconducteurs constituant la structure de puits quantique dans la couche appliquée.

10. Procédé selon la revendication 9,
pour laquelle la couche appliquée est une couche de SiN.

11. Procédé selon une quelconque des revendications 7 à 10, pour lequel la structure de puits quantique comporte un matériau semiconducteur III-V.

12. Procédé selon la revendication 11,
pour lequel le matériau semiconducteur III-V comporte du gallium.

13. Procédé selon une quelconque des revendications 7 à 12, pour lequel une facette hautement réflective (4) sur la zone d'injecteur (2) et/ou une facette de sortie (5) est prévue sur une extrémité détournée de la zone d'injecteur (2) de la zone s'élargissant (3), pendant la fabrication de laquelle s'effectue au moins partiellement un mélange.
